# EUROPÄISCHE PATENTSCHRIFT

(11) **EP 2 456 589 B1**
(45) Veröffentlichungstag und Bekanntmachung des Hinweises auf die Patenterteilung: **18.05.2016**
(21) Anmeldenummer: 10744501.7
(22) Anmeldetag: 21.07.2010
(51) Int. Cl.: B23K 1/00, B23K 35/02, H01L 21/60

(54) **BLEIFREIE HOCHTEMPERATURVERBINDUNG**
LEAD FREE HIGH TEMPERATURE CONNECTION
CONNECTION SANS PLOMB À HAUTE TEMPERATURE

(30) Priorität: 22.07.2009 DE 102009034483
(43) Veröffentlichungstag der Anmeldung: 30.05.2012
(73) Patentinhaber: Heraeus Deutschland GmbH & Co. KG, 63450 Hanau (DE)
(72) Erfinder: BREER, Frank, 63875 Mespelbrunn (DE); SCHMITT, Wolfgang, 63110 Rodgau (DE); TRODLER, Jörg, 63526 Erlensee (DE); SCHALLER, Karl-Heinz, 92289 Ursensollen (DE)
(74) Vertreter: Heraeus IP
(86) Internationale Anmeldenummer: PCT/EP2010/004447
(87) Internationale Veröffentlichungsnummer: WO 2011/009597

(56) Entgegenhaltungen:
- WO-A1-02/068245
- WO-A2-2007/021326
- DE-A1-102007 010 242
- US-A1- 2005 029 666

## Beschreibung

Die vorliegende Erfindung betrifft ein Verfahren gemäß dem Oberbegriff vom Anspruch 3 zum stoffschlüssigen Verbinden eines elektronischen Bauteils mit einem Substrat, eine Lotpaste gemäß dem Oberbegriff vom Anspruch 1, die bei diesem Verfahren zum Einsatz kommt, und eine Anordnung gemäß dem Oberbegriff vom Anspruch 6, die bei diesem Verfahren erhalten werden kann.

Die aus dem Bereich der Mikroelektronik stammenden Baüelemente sind üblicherweise einer Umgebung ausgesetzt, die von ständigen periodischen Temperaturschwankungen geprägt ist. Dies gilt insbesondere für Mikrochips, die mit den entsprechenden Substraten gewöhnlich durch Lötverfahren unter Bildung von Kontaktschichten stoffschlüssig verbunden werden. Dementsprechend ist es für die Qualität der eingesetzten Produkte entscheidend, dass diese Kontaktschichten eine hinreichende Stabilität gegenüber Wärmeermüdung aufweisen.

Daher werden üblicherweise zur Verbindung von Chip und Substrat Lotpasten mit einem hohen Bleigehalt von über 85 Gewichtsprozent eingesetzt. Diese Lotpasten auf Bleibasis verleihen der Verbindung aus Chip und Substrat eine ausreichende Beständigkeit gegenüber Wärmeermüdung in einer Umgebung, die von ständigen periodischen Temperaturschwankungen geprägt ist.

Gemäß der Richtlinie 2002/95/EC der Europäischen Union dürfen vom 01. Juli 2006 an keine elektrischen und elektronischen Geräte mehr vertrieben werden, die Blei oder andere gesundheitsgefährdende Substanzen erhalten. Dies führte in der Folge zur Entwicklung von bleifreien Lotpasten für verschiedene elektrische und elektronische Anwendungen. Eine Ausnahme von der genannten Richtlinie betrifft allerdings Lote für die Anwendung im Hochtemperaturbereich. Mangels Alternativen ist hier weiterhin der Einsatz von Blei gestattet, zumindest solange, bis gleichwertige bleifreie Alternativen zur Verfügung stehen. Dementsprechend ist es das Ziel, Anordnungen aus Chips und Substraten zu entwickeln, die keine bleihaltigen Kontaktschichten aufweisen.

Die bisher als Alternative zum stoffschlüssigen Verbinden von Chips und Substraten verwendeten bleifreien Lotpasten sind Schmelzlotpasten, die neben einem Flussmittel üblicherweise Pulver mit Partikeln aus einer Metalllegierung, die vornehmlich aus Zinn, Silber und/oder Kupfer besteht, enthalten, wobei die Partikel einen mittleren Teilchendurchmesser von 25 - 45 um oder mehr aufweisen.

In Untersuchungen wurde herausgefunden, dass die durch Verwendung dieser Lotpasten entstehenden Kontaktschichten nicht nur aus Lotgefüge bestehen, sondern darüber hinaus auch hochtemperaturfeste metallische Verbindungen, sogenannte intermetallische Phasen, enthalten. Dabei verlaufen intermetallische Phasen und die eutektische Phase des Lotgefüges im Wesentlichen parallel zueinander und zu den zu verbindenden Oberflächen von Chip und Substrat und bilden so eine Sandwichstruktur aus. Da die unterschiedlichen Phasen dieser Sandwichstruktur verschiedene thermische Ausdehnungskoeffizienten haben, weisen diese Kontaktstellen nur eine begrenzte thermische und mechanische Belastbarkeit auf.

Ferner wurde versucht, stabile stoffschlüssige Verbindungen zwischen Chip und Substrat durch Diffusionslöten zu schaffen. Dabei bilden ein bei niedriger Temperatur schmelzende Lotmaterial und bei hoher Temperatur schmelzende Metalle eine hochtemperaturfeste und mechanisch stabile intermetallische Phase. Das Lotmaterial wird dabei vollständig in die intermetallische Phase umgewandelt.

Beispielsweise offenbart die DE 10 2007 010 242 ein Verfahren zum Befestigen von Chips auf Substraten durch Diffusionslöten. Gemäß der DE 10 2007 010 242 werden hierzu zunächst feste Lotschichten mit einer Dicke von wenigen Mikrometern durch Sputtern und Galvanisieren auf die zu verbindenden Metallflächen aufgebracht, was zwei thermische Schritte zum Aufbringen des Festlotdepots notwendig macht. Durch anschließendes Diffusionslöten entsteht zwischen dem Chip und dem Substrat eine Kontaktschicht, die nur intermetallische Phasen enthält. Dadurch gewinnt der geschaffene Kontakt zwar gegenüber einer gleichermaßen dicken Kontaktstelle, die durch Schmelzlöten hergestellt wird, an Festigkeit. Andererseits wäre es aber wünschenswert, die Dicke der Kontaktschicht zu erhöhen, um damit eine weitere Erhöhung der Festigkeit zu erreichen.

WO 2007/021326 offenbart eine Lotpaste gemäß dem Oberbegriff vom Anspruch 1, ein Verfahren zumstoffschlüssigen Verbinden eines elektronischen Bauteils mit einen Substrat, beiden man
a) ein elekronisches Bauteil mit einer ersten zu verbinden den Oberfläche und ein Substrat mit einer zweiten zu verbindenden Oberfläche bereitstellt,
b) auf wenigstens eine der zu verbindenden Oberfläche eine Latpaste aufträgt,
c) das elektronische Bauteil und das Substrat so anordnet, dass die erste zu verbindende Oberfläche des Substrats über die Lotpaste in Kontakt stekt,
d) die Anordnung aus c) verlötet, um eine stoffschlüssige Verbindung zwischen dem elektronischen Bauteil und dem Substrat zu erzeugen,
und eine Anordnung gemäß dem Oberbegriff vom Anspruch 6.

Es besteht daher erfindungsgemäß die Aufgabe, ein einfaches Verfahren zur stoffschlüssigen Verbindung eines elektronischen Bauteils mit einem Substrat bereitzustellen, das ohne bleihaltige Lotpasten auskommt und zu einer Kontaktschicht führt, die eine ausreichend hohe Beständigkeit gegenüber Wärmeermüdung in einer Umgebung, die von ständigen periodischen Termperaturschwankungen geprägt ist, sowie eine hohe thermische und elektrische Leitfähigkeit aufweist.

Diese Aufgabe wird gelöst durch ein Verfahren gemäß Anspruch 3 zum stoffschlüssigen Verbinden eines elektronischen Bauteils mit einem Substrat, bei dem man
a) ein elektronisches Bauteil mit einer ersten zu verbindenden Oberfläche und ein Substrat mit einer zweiten zu verbindenden Oberfläche bereitstellt,
b) auf wenigstens eine der zu verbindenden Oberflächen eine Lotpaste aufträgt,
c) das elektronische Bauteil und das Substrat so anordnet, dass die erste zu verbindende Oberfläche des elektronischen Bauteils mit der zweiten zu verbindenden Oberfläche des Substrats über die Lotpaste in Kontakt steht, und
d) die Anordnung aus c) verlötet, um eine stoffschlüssige Verbindung zwischen dem elektronischen Bauteil und dem Substrat zu erzeugen, wobei die Lotpaste (i) 10 - 30 Gewichtsprozent Kupferpartikel, (ii) 60 - 80 Gewichtsprozent Partikel aus wenigstens einem Stoff, der aus der Gruppe ausgewählt ist, die aus Zinn und Zinn-Kupfer-Legierungen besteht, und (iii) 3 - 30 Gewichtsprozent Flussmittel enthält, wobei der mittlere Teilchendurchmesser der Kupferpartikel und der Partikel aus einem Stoff, der aus der Gruppe ausgewählt ist, die aus Zinn und Zinn-Kupfer-Legierungen besteht, nicht mehr als 15 µm beträgt, und wobei die Auftragsdicke der Lotpaste wenigstens 20 µm beträgt.

Für dieses Verfahren wird demnach eine Lotpaste gemäß Anspruch 1 eingesetzt, die
(i) 10 - 30 Gewichtsprozent Kupferpartikel
(ii) 60 - 80 Gewichtsprozent Partikel aus wenigstens einem Stoff, der aus der Gruppe ausgewählt ist, die aus Zinn und Zinn-Kupfer-Legierungen besteht, und
(iii) 3 - 30 Gewichtsprozent Flussmittel enthält,
wobei der mittlere Teilchendurchmesser der Kupferpartikel und der Partikel aus wenigstens einem Stoff, der aus der Gruppe ausgewählt ist, die aus Zinn und Zinn-Kupfer-Legierungen besteht, nicht mehr als 15 µm beträgt.

Erfindungsgemäß wird dementsprechend eine Anordnung gemäß Anspruch 6 bereitgestellt, aufweisend ein elektronisches Bauteil, ein Substrat und eine dazwischenliegende Kontaktschicht, durch die das elektronische Bauteil und das Substrat stoffschlüssig verbunden sind, wobei die Kontaktschicht einen Anteil aus eutektischer Phase und einen Anteil aus intermetallischer Phase aufweist, wobei der Anteil an eutektischer Phase; bezogen auf das Gesamtgewicht von eutektischer Phase und intermetallischer Phase, im Bereich von 5 - 50 Gewichtsprozent liegt.

Dem erfindungsgemäßen Verfahren liegt die überraschende Erkenntnis zugrunde, dass es während des Lötens der Anordnung aus Substrat, elektronischem Bauteil und dazwischenliegender erfindungsgemäßer Lotpaste zunächst zu einem thermischen Erstarren des Lotmaterials kommt, das zu einer Befestigung von Substrat und elektronischem Bauteil über eine intermediäre gebildete Kontaktschicht führt, die zunächst aus eutektischer Phase besteht. Unmittelbar danach erfolgt eine isothermische Verfestigung der intermediär gebildeten Kontaktschicht unter Bildung von intermetallischen Phasen. Dabei wird die eutektische Phase mit intermetallischer Phase durchsetzt, wobei die zwischen intermetallischer Phase und übriger Kontaktschicht gebildeten Phasengrenzen nicht parallel zueinander und zu den Oberflächen von elektronischem Bauteil und Substrat verlaufen, sondern eine Kontaktschicht mit einem Anteil aus eutektischer Phase und einem Anteil aus intermetallischer Phase bilden, wobei der Anteil an eutektischer Phase bezogen auf das Gesamtgewicht an eutektischer Phase und intermetallischer Phase im Bereich von 5 - 50 Gewichtsprozent liegt.

Durch die Ausbildung einer solchen Kontaktschicht kommt es sowohl im Vergleich zu einer beim Diffusionslöten erzeugten dünnen (nur wenige Mikrometer dicken) Kontaktschicht, die lediglich intermetallische Phase enthält, als auch zu einer beim Schmelzlöten erzeugten Kontaktschicht, die eutektische und intermetallische Phasen aufweisen, die im wesentlichen parallel zu den zu verbindenden Oberflächen verlaufen, und überwiegend eutektische Phase enthält, zu einer erheblichen Festigkeitssteigerung. Somit lassen sich auch die mit der Oberflächenrauigkeit der zu verbindenden Objekte, dem beim Diffusionslöten limitierten Lotauftrag und dem Warpage (Verbiegungen der Oberfläche während des Lötens) einhergehenden Probleme beseitigen, wodurch es zu einer stabileren Verbindung zwischen Substrat und elektronischen Bauteil kommt.

Erfindungsgemäß können somit Kontaktschichten geschaffen werden, die eine für durch Diffusionslöten gebildete Kontaktschichten typische hohe Temperaturbeständigkeit aufweisen, ohne dass dabei thermische und elektrische Leitfähigkeit verringert werden.

Es wurde gefunden, dass es für die Ausbildung dieser stabilen Kontaktschichten wesentlich ist, für die Lotpaste eine hinreichend große Auftragsdicke zu wählen. Beträgt die Auftragsdicke nur wenige Mikrometer, so kommt es beim Löten unmittelbar zur Ausbildung von intermetallischen Phasen, wobei eine spätere Durchsetzung mit eutektischer Phase ausgeschlossen ist. Dadurch kann die erfindungsgemäß vorgesehene Festigkeitssteigerung nicht erreicht werden.

Ferner hat sich herausgestellt, dass der gewünschte Festigkeitsgewinn nur dann erreicht wird, wenn der Lotpaste Kupferpartikel mit einer bestimmten Größe und in einer bestimmten Menge zugegeben werden. Ohne an eine Theorie gebunden sein zu wollen, scheint von diesen Kupferpartikeln stammendes Kupfer beim Abkühlen unter die Liquidustemperatur des Lots in eine intermediär gebildete eutektische Phase unter Ausbildung einer von eutektischer Phase durchsetzten intermetallischen Phase zu diffundieren.

Erfindungsgemäß wird unter elektronischem Bauteil ein Bestandteil einer elektrischen Schaltung verstanden. Bei dem elektrischen Bauteil kann es sich beispielsweise um einen Chip, vorzugsweise einen Nacktchip (ungehäuster Halbleiterchip), um eine Halbleiterdiode, um einen Transistor, um einen Widerstand oder um einen Kondensator handeln.

Im Rahmen der Erfindung wird unter Substrat ein Körper verstanden, mit dem das elektronische Bauteil verbunden ist. Beispielsweise kann es sich bei dem Substrat um eine Leiterplatte, um Direct-Bonded-Copper (DBC bzw. DCB) oder um einen Leadframe handeln.

Der Begriff Leiterplatte wird hierin synonym für Leiterkarte, Platine oder gedruckte Schaltung verwendet und beschreibt einen Träger für elektronische Bauteile. Leiterplatten bestehen aus elektrisch isolierendem Material mit daran haftenden, leitenden Verbindungen (Leiterbahnen). Als elektrisch isolierendes Material kann bspw. faserverstärkter Kunststoff verwendet werden.

Direct-Bonded-Copper bezeichnet eine keramische Platte (bspw. aus Alumina, Aluminiumnitrid oder Berylliumoxid), wobei eine Oberfläche oder die beiden flächenmäßig größten, zueinander parallelen Oberflächen mit Kupfer über einen Oxidationsprozess bei hohen Temperaturen gebondet sind. Unter den gewählten Bedingungen bildet sich dabei ein Eutektikum aus Kupfer und Sauerstoff, das sich sowohl mit dem Kupfer als auch dem Oxid des Substrats verbindet.

Unter Leadframe wird ein IC (integrated circuit, Mikrochip)-Gehäuse verstanden, das im Wesentlichen nur aus einem Chipträger und Anschlussleitungen besteht. Der Begriff Leadframe wird hierin synonym mit den Begriffen Anschlussrahmen oder Chipträger verwendet. Der Chipträger weist ein Substrat auf, das dessen Grundgerüst bildet und aus Metall, bspw. Kupfer, Kupferlegierungen, einer Kombination von Kupfer mit einem Finisher (z.B. Nickel, Silber oder Gold), Eisen-Nickel-Legierungen oder anderen Invar-Legierungen gefertigt ist.

Das elektronische Bauteil weist wenigstens eine erste Oberfläche auf, die für die Verbindung des elektronischen Bauteils mit einer Oberfläche des Substrats über die durch die Lotpaste geschaffene Kontaktschicht vorgesehen ist. Diese Oberfläche kann auch Teil einer größeren Oberfläche sein.

Das Substrat weist wenigstens eine zweite Oberfläche auf, die für die Verbindung des Substrat mit der vorstehend beschriebenen Oberfläche des elektronischen Bauteils über die durch die Lotpaste geschaffene Kontaktschicht vorgesehen ist. Diese Oberfläche kann ebenfalls auch Teil einer größeren Oberfläche sein.

Die über die durch die Lotpaste geschaffene Kontaktschicht mit dem Substrat in Verbindung stehende Oberfläche des elektronischen Bauteils wird erfindungsgemäß als "erste zu verbindende Oberfläche" und die über die durch die Lotpaste geschaffene Kontaktschicht mit dem elektronischen Bauteil in Verbindung stehende Oberfläche des Substrats als "zweite zu verbindende Oberfläche" bezeichnet.

Üblicherweise ist auf wenigstens der ersten zu verbindenden Oberfläche des elektronischen Bauteils eine Metallisierungsschicht aufgebracht. Ebenfalls üblich ist es, dass auf wenigstens der zweiten zu verbindenden Oberfläche des Substrats eine Metallisierungsschicht aufgebracht ist. Üblicherweise enthalten sowohl elektronisches Bauteil als auch Substrat auf wenigstens den zu verbindenden Oberflächen eine Metallisierungsschicht. Es ist somit üblich, dass das elektronische Bauteil auf einer Oberfläche eine Metallisierungsschicht aufweist, die einer Metallisierungsschicht auf der Oberfläche des Substrats gegenüberliegt, und dass diese Metallisierungsschichten durch die Kontaktschicht miteinander in Verbindung stehen. Im Rahmen der Erfindung sind die gegebenenfalls enthaltenen Metallisierungsschichten des elektronischen Bauteils Teil des elektronischen Bauteils und die gegebenenfalls enthaltenen Metallisierungsschichten des Substrats Teil des Substrats.

Falls vorhanden, nimmt die Metallisierungsschicht vorzugsweise eine Fläche von wenigstens 50%, mehr bevorzugt wenigstens 70%, noch mehr bevorzugt wenigstens 90% und ganz bevorzugt wenigstens 95%, wie zum Beispiel 100% von wenigstens einer der Oberflächen des elektronischen Bauteils ein. Auf dem Substrat nimmt die Metallisierungsschicht vorzugsweise eine Fläche von wenigstens 50%, mehr bevorzugt wenigstens 70%, noch mehr bevorzugt wenigstens 90% und ganz bevorzugt wenigstens 95%, wie zum Beispiel 100%, der über die Kontaktschicht mit dem elektronischen Bauteil in Verbindung stehenden Oberfläche ein.

Bei der Metallisierungsschicht handelt es sich vorzugsweise um eine Schicht, die lötbare Verbindungen enthält. Vorzugsweise enthält die Metallisierungsschicht ein Element, das aus der Gruppe ausgewählt ist, die aus Kupfer, Silber, Gold, Zinn und Palladium besteht. Die Metallisierungsschicht kann auch vollständig aus diesen Elementen, lötbaren Verbindungen dieser Elemente oder Mischungen oder Legierungen dieser Elemente bestehen.

Auf wenigstens eine der zu verbindenden Oberflächen von elektronischem Bauteil oder Substrat wird erfindungsgemäß eine Lotpaste aufgetragen.

Diese Lotpaste enthält (i) 10 - 30 Gewichtsprozent Kupferpartikel, (ii) 60 - 80 Gewichtsprozent Partikel aus wenigstens einem Stoff, der aus der Gruppe ausgewählt ist, die aus Zinn und einer Zinn-Kupfer-Legierung besteht, und (iii) 3 - 30 Gewichtsprozent Flussmittel.

Die Reinheit des Kupfers der in der Lotpaste enthaltenen Kupferpartikel beträgt vorzugsweise wenigstens 99,9 % (3 N) und mehr bevorzugt wenigstens 99,99 % (4 N).

Der Anteil an Kupferpartikeln in der Lotpaste beträgt 10 - 30 Gewichtsprozent, vorzugsweise 12 - 28 Gewichtsprozent und mehr bevorzugt 15 - 25 Gewichtsprozent, bezogen auf das Gewicht der Lotpaste.

Der Anteil an Partikeln aus wenigstens einem Stoff, der aus der Gruppe ausgewählt ist, die aus Zinn und einer Zinn-Kupfer-Legierung besteht, beträgt 60 - 80 Gewichtsprozent, vorzugsweise 62 - 78 Gewichtsprozent und mehr bevorzugt 65 - 75 Gewichtsprozent, bezogen auf das Gewicht der Lotpaste.

Sind in der Lotpaste Partikel aus einer Zinn-Kupfer-Legierung enthalten, so liegt der Anteil von Zinn vorzugsweise im Bereich von 97 - 99,5 Gewichtsprozent und mehr bevorzugt im Bereich von 98 - 99,5 Gewichtsprozent, und der Anteil von Kupfer vorzugsweise im Bereich von 0,5 - 3 Gewichtsprozent und mehr bevorzugt im Bereich von 0,5 - 2 Gewichtsprozent. Gemäß einer besonders bevorzugten Ausführungsform handelt es sich bei der Zinn-Kupfer-Legierung um eine Legierung, die 99,3 Gewichtsprozent Zinn und 0,7 Gewichtsprozent Kupfer aufweist. Erfindungsgemäß wesentlich ist, dass die in der Lotpaste enthaltenen Partikel einen geringen durchschnittlichen Teilchendurchmesseraufweisen. Nur Lotpasten, die Partikel mit hinreichend geringen durchschnittlichen Teilchendurchmessern aufweisen, sind geeignet, beim Löten zunächst eine eutektische Phase zur Befestigung von elektronischem Bauteil und-Substrat zu bilden und danach das Durchwachsen der eutektischen Phase mit intermetallischer Phase zu ermöglichen.

Der mittlere Teilchendurchmesser der Kupferpartikel und der mittlere Teilchendurchmesser der Partikel aus wenigstens einem Stoff, der aus der Gruppe ausgewählt ist, die aus Zinn oder einer Zinn-Kupfer-Legierung besteht, betragen unabhängig voneinander nicht mehr als 15 µm, vorzugsweise nicht mehr als 13 µm, mehr bevorzugt nicht mehr als 11 µm und noch mehr bevorzugt nicht mehr als 8 µm Vorzugsweise liegt der mittlere Teilchendurchmesser im Bereich von 2 - 15 µm, mehr bevorzugt im Bereich von 2 - 13 µm, noch mehr bevorzugt im Bereich von 2-11 µm und ganz besonders bevorzugt im Bereich von 2 - 8 µm.

Unter mittlerem Teilchendurchmesser wird erfindungsgemäß verstanden, dass wenigstens 90 Prozent der Partikel einen Teilchendurchmesser im angegebenen Bereich aufweisen. Beispielsweise bedeutet ein mittlerer Teilchendurchmesser von nicht mehr als 15 µm, dass wenigstens 90 Prozent der Partikel einen Teilchendurchmesser von nicht mehr als 15 µm und weniger als 10 Prozent der Partikel einen Teilchendurchmesser von mehr als 15 µm aufweisen. Ein mittlerer Teilchendurchmesser im Bereich von 2 - 15 µm bedeutet dementsprechend, dass wenigstens 90 Prozent der Partikel einen Teilchendurchmesser im Bereich von 2 - 15 µm und weniger als 10 Prozent der Partikel einen Teilchendurchmesser von weniger als 2 µm oder mehr als 15 µm aufweisen.

Erfindungsgemäß kann es bevorzugt sein, dass weniger als 1 Prozent der Partikel einen bestimmten Teilchendurchmesser überschreiten. Dieser Teilchendurchmesser, der von weniger als 1 Prozent der Partikel überschritten werden darf, beträgt vorzugsweise 15 µm, mehr bevorzugt 11 µm und noch mehr bevorzugt 8 µm.

Es kann erfindungsgemäß auch bevorzugt sein, dass in der Lotpaste keine Partikel enthalten sind, die einen Teilchendurchmesser von mehr als 20 µm, von mehr als 18 µm, von mehr als 15 µm oder von mehr als 11 µm aufweisen.

Die Kupferpartikel und die Partikel aus wenigstens einem Stoff, der aus der Gruppe ausgewählt ist, die aus Zinn und einer Zinn-Kupfer-Legierung besteht, können unterschiedliche Geometrien aufweisen. Die Partikel weisen jedoch vorzugsweise eine sphärische Form auf. Dem Fachmann ist jedoch klar, dass von den eingesetzten Partikeln herstellüngsbedingt auch ein untergeordneter Anteil eine nicht sphärische Form aufweisen kann. Es ist jedoch bevorzugt, dass wenigstens 90 Gewichtsprozent, mehr bevorzugt wenigstens 95 Gewichtsprozent, noch mehr bevorzugt wenigstens 99 Gewichtsprozent oder 100 Gewichtsprozent der Partikel in sphärischer Form vorliegen. Es ist auch bevorzugt, dass in der Lotpaste weniger als 5 Gewichtsprozent, mehr bevorzugt weniger als 1 Gewichtsprozent, noch mehr bevorzugt weniger als 0,1 Gewichtsprozent, so zum Beispiel 0 Gewichtsprozent der Partikel in der Form von Flakes vorliegen.

Erfindungsgemäß sind in der Lotpaste 3 - 30 Gewichtsprozent, vorzugsweise 5 - 20 Gewichtsprozent und mehr bevorzugt 6 - 15 Gewichtsprozent Flussmittel enthalten. Das Flussmittel soll in der Lage sein, die Oberfläche beim Löten zu reduzieren (d.h. zu entoxidieren), die erneute Oxidbildung vor und während des Lötvorgangs zu verhindern und Einschlüsse von Fremdstoffen zu verringern. Ferner soll durch den Zusatz des Flussmittels die Oberflächenspannung des flüssigen Lotes verringert werden. Als Flussmittel können bspw. Kolophonium, auf Kolophonium basierende Harzsysteme, auf Wasser basierende Harzsysteme oder Systeme auf der Basis von Carbonsäuren (z.B. Carbonsäuren mit 2 - 50 C-Atomen und bis zu zwei aromatischen Ringen, wie Zitronensäure Adipinsäure, Zimtsäure und Benzylsäure), Aminen (z.B. Amine mit 6 - 100 C-Atomen, die vorzugsweise tertiär sein können) und Lösungsmitteln (z.B. polare Lösungsmittel, enthaltend Wasser und ein Polyol, wie Glykol oder Glycerin) verwendet werden.

Daneben können in der erfindungsgemäßen Lotpaste weitere Bestandteile, wie zum Beispiel Alkohole, Fettsäuren (z.B. gesättigte Fettsäuren, wie Ölsäure, Myristinsäure, Palmitinsäure, Margarinsäure, Stearinsäure oder Arachinsäure), Polysiloxan-Verbindungen oder Phosphid-Verbindungen, enthalten sein.

Die erfindungsgemäß eingesetzte Lotpaste enthält kein Blei und ist damit bleifrei. Erfindungsgemäß ist unter bleifrei zu verstehen, dass die Lotpaste abgesehen von gegebenenfalls vorhandenen, technisch bedingten Blei-Verunreinigungen kein Blei enthält. Unter bleifrei wird demnach ein Bleigehalt von unter 1, vorzugsweise unter 0,5, mehr bevorzugt unter 0,1, noch mehr bevorzugt unter 0,01 Gewichtsprozent und insbesondere 0 Gewichtsprozent auf Basis des Gewichts der Lotpaste verstanden.

Elektronisches Bauteil und Substrat werden erfindungsgemäß durch Löten stoffschlüssig miteinander verbunden. Stoffschlüssige Verbindungen sind demnach Verbindungen, bei denen die Verbindungspartner durch atomare oder molekulare Kräfte zusammengehalten.werden. Sie stellen vorzugsweise nicht lösbare Verbindungen dar, die sich nur durch Zerstörung der Verbindungsmittel trennen lassen.

Erfindungsgemäß wird zunächst eine Anordnung gebildet, die aus dem Substrat, dem elektronischen Bauteil und einer zwischen Substrat und elektronischem Bauteil befindlichen Schicht aus Lotpaste besteht. Dementsprechend sind Substrat und elektronisches Bauteil so angeordnet, dass die erste zu verbindende Oberfläche des Substrats und die zweite zu verbindende Oberfläche des elektronischen Bauteils miteinander über die Lotpaste in Kontakt stehen. Üblicherweise steht die Lotpaste dabei vorzugsweise mit der gegebenenfalls vorhandenen Metallisierungsschicht des Substrats und der gegebenenfalls vorhandenen Metallisierungsschicht des elektronischen Bauteils in Kontakt.

Vorzugsweise wird dazu zunächst eine Schicht aus Lotpaste auf die zu verbindende Oberfläche des Substrats, vorzugsweise auf die eine Metallisierungsschicht enthaltende Oberfläche des Substrats, aufgetragen. Das Aufbringen kann durch eines der aus dem Stand der Technik bekannten Verfahren, bspw. Siebdruckverfahren, Schablonendruckverfahren oder Dispenstechnik, erfolgen. Es ist nicht erforderlich, dass die Lotpaste die gesamte Oberfläche des Substrats bedeckt. Vielmehr kann die Lotpaste auch nur auf Teile der Oberfläche des Substrats, bspw. auf ausgewählte Lötflächen, aufgebracht werden. Anschließend wird das elektronische Bauteil mit einer Oberfläche, vorzugsweise mit der die Metallisierungsschicht enthaltenden Oberfläche, auf die aufgetragene Lotpaste gesetzt.

Die Auftragsdicke der Lotpaste beträgt erfindungsgemäß wenigstens 20 µm, mehr bevorzugt wenigstens 25 µm und noch mehr bevorzugt wenigstens 50 µm. Gemäß einer bevorzugten Ausführungsform liegt die Auftragsdicke im Bereich von 20 - 150 µm, mehr bevorzugt im Bereich von 30 - 120 µm und besonders bevorzugt im Bereich von 50 - 100 µm. Unter Auftragsdicke wird erfindungsgemäß der Abstand zwischen den zu verbindenden Oberflächen von Substrat und elektronischem Bauteil, vorzugsweise zwischen den Metallisierungsschichten der zu verbindenden Oberflächen von Substrat und elektronischem Bauteil, unmittelbar vor dem Löten verstanden. Die Auftragsdicke wird somit im Wesentlichen von der Menge der verwendeten Lotpaste bestimmt. Beim anschließenden Lötvorgang kommt es zu einer signifikanten Reduzierung des Abstands zwischen elektronischem Bauteil und Substrat, die, je nach genauer Zusammensetzung der Lotpaste, um die 50 Prozent betragen kann. Dies ist unter anderem auf das Verdampfen des Flussmittels während des Lötprozesses zurückzuführen.

Die Anordnung aus elektronischem Bauteil, Substrat und dazwischenliegender Lotpaste wird schließlich unter Bildung einer Anordnung aus elektronischem Bauteil, Substrat und dazwischenliegender Kontaktschicht gelötet. Unter Löten wird dabei gemäß der allgemeinen Definition ein thermisches Verfahren zum stoffschlüssigen Fügen und Beschichten von Werkstoffen verstanden, wobei die Solidustemperatur der Werkstoffe nicht erreicht wird.

Zum Löten wird die vorstehend beschriebene Anordnung vorzugsweise gleichmäßig bis zum Erreichen der eigentlichen Löttemperatur erhitzt. Gemäß einer bevorzugten Ausführungsform erfolgt das Erhitzen mit einer Geschwindigkeit von nicht mehr als 3 °C pro Sekunde.

Die Löttemperatur liegt vorzugsweise etwa 10 - 30 °C, mehr bevorzugt etwa 15 - 25 °C und noch mehr bevorzugt etwa 18 - 22 °C, zum Beispiel etwa 20 °C über der Schmelztemperatur des verwendeten Lots. Gemäß einer weiteren bevorzugten Ausführungsform liegt die Löttemperatur unterhalb von 260°C, so zum Beispiel im Bereich von 240 - 250°C.

Zum Löten wird die Temperatur für eine Zeit von wenigstens 15 Sekunden, vorzugsweise von wenigstens 20 Sekunden und noch mehr bevorzugt von wenigstens 30 Sekunden über der Liquidustemperatur des in der Lotpaste enthaltenen Lots aufrecht erhalten.

Erfindungsgemäß kommt es während des Abkühlens der gelöteten Anordnung unter die Liquidustemperatur des in der Lotpaste enthaltenen Lots zu einer Diffusion des von den Kupferpartikeln stammenden Kupfers in die beim Lötvorgang entstandene eutektische Zinn-Kupfer-Phase. Dieser Diffusionsprozess führt letztlich zum Durchwachsen der eutektischen Phase mit intermetallischer Phase und hat einen Festigkeitsgewinn des bereits geschaffenen Kontakts zur Folge.

Zur Verstärkung dieses Effekts kann es vorteilhaft sein, die beim Lötvorgang erhaltene Anordnung aus elektronischem Bauteil, Substrat und dazwischenliegender Kontaktschicht nach dem Lötvorgang zu tempern. Unter Tempern wird eine Wärmebehandlung der Anordnung unterhalb der Liquidustemperatur des Lots verstanden.

Die Wärmebehandlung erfolgt vorzugsweise bei einer Temperatur von über 40°C, bspw. im Bereich von 40 - 217°C, mehr bevorzugt im Bereich von 100 - 210 °C und noch mehr bevorzugt im Bereich von 150 - 205 °C. Das Tempern erfolgt vorzugsweise für eine Dauer von 1 Minute bis zu 24 Stunden, mehr bevorzugt für 10 Minuten bis zu 10 Stunden und noch mehr bevorzugt für 20 Minuten bis zu 1 Stunde. Die Temperdauer korreliert üblicherweise mit der Temperatur und ist umso länger, je niedriger-die Temperatur zum Tempern ist.

Besonders vorteilhaft ist, dass das erfindungsgemäße Verfahren keine kostspieligen Abänderungen der üblichen Verfahren zur Herstellung von Anordnungen aus elektronischem Bauteil, Substrat und dazwischenliegender Kontaktschicht verlangt. Insbesondere stellt das erfindungsgemäße Verfahren auch keine besonderen Anforderungen an die für herkömmliche Lötprozesse verwendeten Maschinen. So kann das erfindungsgemäße Verfahren beispielsweise unter herkömmlichen Bedingungen und unter Einsatz der gegebenenfalls bereits vorhandenen Maschinen durchgeführt werden.

Gemäß einer bevorzugten Ausführungsform ist die erfindungsgemäße Anordnung durch das vorstehend beschriebene Verfahren herstellbar oder wird mit diesem Verfahren hergestellt.

Überraschenderweise wurde festgestellt, dass der erfindungsgemäß hergestellten Anordnung aus elektronischem Bauteil, Substrat und dazwischenliegender Kontaktschicht durch das beschriebene Verfahren überragende Eigenschaften verliehen werden. So wird durch die geschaffene bleifreie Kontaktschicht, die elektronisches Bauteil und Substrat miteinander verbindet, ein Zuverlässigkeitsgewinn erreicht gegenüber Anordnungen mit Kontaktschichten, die mittels bekannter Verfahren hergestellt werden.

Dies ist überraschenderweise darauf zurückzuführen, dass die erfindungsgemäß hergestellte Kontaktschicht eine eutektische Phase darstellt, die von intermetallischer Phase durchwachsen ist.

Aufgrund des Durchwachsens der eutektischen Phase mit intermetallischen Phasen wird die Ausbildung langer Grenzbereiche zwischen sich parallel zu den Oberflächen von Substrat und elektronischem Bauteil erstreckenden eutektischen und intermetallischen Phasen verhindert. Folglich weisen die Kontaktschichten keine räumlich ausgedehnten Grenzbereiche von Phasen mit unterschiedlichen thermischen Ausdehnungskoeffizienten auf, wodurch ein Festigkeitsgewinn erzielt werden kann.

Daher ist die erfindungsgemäße Anordnung aus Substrat, elektronischem Bauteil und dazwischenliegender Kontaktschicht in der Lage, den bei den insbesondere im Betrieb von Hochleistungshalbleitern auftretenden, starken periodischen Temperaturschwankungen standzuhalten.

Diese Anordnung weist demnach ein elektronisches Bauteil, ein Substrat und eine zwischen dem elektronischen Bauteil und dem Substrat angeordnete Kontaktschicht auf, wobei die Kontaktschicht einen Anteil aus eutektischer Phase und einen Anteil aus intermetallischer Phase aufweist, wobei der Anteil an eutektischer Phase, bezogen auf das Gesamtgewicht von eutektischer Phase und intermetallischer Phase, im Bereich von 5 - 50 Gewichtsprozent liegt.

Dieser hohe Anteil von intermetallischer Phase an der Kontaktschicht, die im Übrigen eutektische Phase enthält, wird dadurch erreicht, dass die intermetallischen Phasen nicht parallel zu den zu verbindenden Oberflächen von elektronischem Bauteil und Substrat und zu eutektischer Phase angeordnet, sondern mit letzterer verwachsen sind.

Der Anteil an intermetallischer Phase und eutektischer Phase kann beispielsweise durch ein Ätz- und Gravimetrieverfahren bestimmt werden. Hierzu wird die zu untersuchende Kontaktschicht aus der Anordnung herausgetrennt, gemahlen und gewogen, um das Gesamtgewicht der Kontaktschicht aus eutektischer Phase und intermetallischer Phase zu bestimmen. Anschließend wird die gemahlene Kontaktschicht mit 2-Nitrophenol versetzt und für eine Stunde bei 50°C stehen gelassen. Bei dieser Tiefenätzung wird die eutektische Phase aus der gemahlenen Kontaktschicht herausgelöst, während intermetallische Phasen als unlösliche Bestandteile zurückbleiben. Der Anteil an eutektischer Phase wird danach durch Differenzwägung aus dem Gewicht der gemahlenen Kontaktschicht vor der Tiefenätzung und dem Gewicht an intermetallischer Phase bestimmt.

Bei der in der erfindungsgemäßen Anordnung enthaltenen Kontaktschicht sind eutektische Phase und intermetallische Phasen nicht im Wesentlichen parallel zueinander und zu den zu verbindenden Oberflächen von elektronischem Bauteil und Substrat angeordnet. Vielmehr sind in der Kontaktschicht vorzugsweise eutektische Phasen enthalten, die von intermetallischen Phasen umschlossen sind. Gemäß einer bevorzugten Ausführungsform enthält die Kontaktschicht Körper aus eutektischer Phase mit einem Volumen von wenigstens 1000 µm³, die vollständig von intermetallischer Phase umschlossen sind. Vorzugsweise beträgt der Anteil dieser Körper an der Kontaktschicht wenigstens 1 Volumenprozent, mehr bevorzugt wenigstens 3 Volumenprozent und noch mehr bevorzugt wenigstens 5 Volumenprozent. Der Anteil dieser Körper an der Kontaktschicht kann auf einfache Weise durch Auswertung von Schliffbildern ermittelt werden.

In der erfindungsgemäßen Anordnung beträgt der Abstand zwischen elektronischem Bauteil und Substrat vorzugsweise 8 - 50 µm, mehr bevorzugt 10 - 30 µm und noch mehr bevorzugt 12 - 28 µm. Dieser Abstand versteht sich als Abstand zwischen den zu verbindenden Oberflächen von elektronischem Bauteil und Substrat, wobei die ggf. vorhandenen Metallisierungsschichten dem elektronischen Bauteil bzw. dem Substrat zuzuordnen sind. Der genannte Abstand entspricht somit der Dicke der Kontaktschicht zwischen elektronischem Bauteil und Substrat nach dem Löten.

Erfindungsgemäß können beim vorstehend beschriebenen Lötvorgang die Lötbedingungen, insbesondere Auftragsdicke der Lotpaste, Temperatur und Zeit, sowie ggf. die Temperbedingungen, insbesondere Temperatur und Zeit, so eingestellt werden, dass die vorstehend beschriebene Kontaktschicht erhalten wird. Die Erzeugung der Kontaktschicht mit den gewünschten Eigenschaften kann auf einfache Weise durch Auswertung entsprechender Schliffbilder nachvollzogen werden.

Die Erfindung wird durch die nachstehenden Beispiele weiter beschrieben, ohne dass diese jedoch als einschränkend zu verstehen sind.

### Beispiele:

### Beispiel 1:

Es wurde eine Lotpaste hergestellt, die 74 Gewichtsprozent Partikel einer Zinn-Kupfer-Legierung (SnCu0,7), die einen durchschnittlichen Teilchendurchmesser im Bereich von 5 - 15 µm aufwiesen, 15 Gewichtsprozent Kupferpartikel, die einen durchschnittlichen Teilchendurchmesser von bis zu 5 µm aufwiesen, und 11 Gewichtsprozent eines Flussmittelsystems auf der Basis von Kolophonium enthielt.

Die Lotpaste wurde durch eine Metallschablone auf ein mit einer Metallisierungsschicht aus Kupfer versehenes DCB-Substrat aufgetragen. Die Auftragsdicke der Lotpaste betrug 20 µm. Anschließend wurde die mit Lotpaste versehene Oberfläche des DCB-Substrats mittels einer hierfür vorgesehenen Maschine mit einem Nacktchip bestückt, der eine Fläche von etwa 400 mm² und eine Metallisierungsschicht aus Kupfer aufwies. Hierzu wurde der Nacktchip so auf die Lotpaste gesetzt, dass die Metallisierungsschicht des Nacktchips mit der Metallisierungsschicht des DCB-Substrats über die Lotpaste in Kontakt stand.

Die Anordnung aus DCB-Substrat, Nacktchip und dazwischen angeordneter Lotpaste wurde in einen Lötofen eingebracht, mit einer Rate von 2,5 Kelvin pro Sekunde auf eine Temperatur von 245 °C erhitzt und diese Temperatur für 30 Sekunden zum Löten aufrecht erhalten.

### Vergleichsbeispiel 1:

Es wurde eine Lotpaste hergestellt, die 87 Gewichtsprozent Partikel einer Zinn-Kupfer-Legierung (SnCu0,7), die einen durchschnittlichen Teilchendurchmesser im Bereich von 5 - 15 µm aufwiesen, und 13 Gewichtsprozent eines Flussmittelsystems auf der Basis von Kolophonium enthielt.

Die Lotpaste wurde durch eine Metallschablone auf ein mit einer Metallisierungsschicht aus Kupfer versehenes DCB-Substrat aufgetragen. Die Auftragsdicke der Lotpaste betrug 20 µm. Anschließend wurde die mit Lotpaste versehene Oberfläche des DCB-Substrats mittels einer hierfür vorgesehenen Maschine mit einem Nacktchip bestückt, der eine Fläche von etwa 400 mm² und eine Metallisierungsschicht aus Kupfer aufwies. Hierzu wurde der Nacktchip so auf die Lotpaste gesetzt, dass die Metallisierungsschicht des Nacktchips mit der Metallisierungsschicht des DCB-Substrats über die Lotpaste in Kontakt stand.

Die Anordnung aus DCB-Substrat, Nacktchip und dazwischen angeordneter Lotpaste wurde in einen Lötofen eingebracht, mit einer Rate von 2,5 °C pro Sekunde auf eine Temperatur von 245 °C erhitzt und diese Temperatur für 30 Sekunden zum Löten aufrecht erhalten.

In verschiedenen Versuchen zur Stabilität der gemäß Beispiel und Vergleichsbeispiel hergestellten Anordnungen wurde festgestellt, dass die erfindungsgemäß hergestellte Anordnung eine höhere Wärmebeständigkeit gegenüber der gemäß Vergleichsbeispiel hergestellten Anordnung aufwies.

## Patentansprüche

1. Lotpaste aufweisend
(i) 10 - 30 Gewichtsprozent Kupferpartikel,
(ii) 60 - 80 Gewichtsprozent Partikel aus wenigstens einem Stoff, der aus der Gruppe ausgewählt ist, die aus Zinn und Zinn-Kupfer-Legierungen besteht,
**dadurch gekennzeichnet, dass** dei Lotpaste 3 - 30 Gewichtsprozent Flussmittel aufweist, und dass der mittlere Teilchendurchmesser der Kupferpartikel und der Partikel aus wenigstens einem Stoff, der aus der Gruppe ausgewählt ist, die aus Zinn und Zinn-Kupfer-Legierungen besteht, nicht mehr als 15 µm beträgt.

2. Lotpaste nach Anspruch 1, **dadurch gekennzeichnet, dass** die Lotpaste Partikel einer Zinn-Kupfer-Legierung mit einem Anteil von Zinn im Bereich von 97 - 99,5 Gewichtsprozent und einem Anteil von Kupfer im Bereich von 0,5 - 3 Gewichtsprozent enthält.

3. Verfahren zum stoffschlüssigen Verbinden eines elektronischen Bauteils mit einem Substrat, bei dem man
a) ein elektronisches Bauteil mit einer ersten zu verbindenden Oberfläche und ein Substrat mit einer zweiten zu verbindenden Oberfläche bereitstellt,
b) auf wenigstens eine der zu verbindenden Oberflächen eine Lotpaste gemäß Anspruch 1 oder 2 in einer den Abstand zwischen den zu verbindenden Oberflächen unmittelbar vor dem Löten darstellenden Auftragsdicke von wenigstens 20 µm aufträgt.
c) das elektronische Bauteil und das Substrat so anordnet, dass die erste zu verbindende Oberfläche des elektronischen Bauteils mit der zweiten zu verbindenden Oberfläche des Substrats über die Lotpaste in Kontakt steht, und
d) die das elektronische Bauteil, das Substrat und die zwischen der ersten zu ver bindenden Oberfläche des elektronischen Bauteils und der zweiten zu verbindenden Oberfläche des Substrats befindliche Lotpaste aufweisenden Anordnung aus c) verlötet, um eine stoffschlossige Verbindung zwischen dem elektronischen Bauteil und dem Substrat zu erzeugen.

4. Verfahren gemäß Anspruch 3, **dadurch gekennzeichnet, dass** man in einem zusätzlichen Schritt e) die Anordnung aus d) bei einer Temperatur von wenigstens 40 - 217°C für eine Zeit im Bereich von 1 Minute bis 24 Stunden tempert

5. Verfahren gemäß Anspruch 3 oder 4, **dadurch gekennzeichnet, dass** das Substrat aus der Gruppe ausgewählt ist, die aus einer Leiterplatte, einem Leadframe und einem Direct-Bonded-Copper-Substrat besteht.

6. Nach einem Verfahren eines der Ansprüche 3 bis 5 hergestellte Anordnung aufweisend ein elektronisches Bauteil, ein Substrat und eine dazwischenliegende das elektronische Bauteil und das Substrat stoffschlüssig verbindende Kontaktschicht, **dadurch gekennzeichnet, dass** die Kontaktschicht einen Anteil aus eutektischer Phase und einen Anteil aus intermetallischer Phase aufweist, wobei der Anteil an eutektischer Phase, bezogen auf das Gesamtgewicht von eutektischer Phase und intermetallischer Phase, im Bereich von 5 - 50 Gewichtsprozent liegt.

## Claims

1. Soldering paste, comprising
(i) 10 - 30% by weight copper particles,
(ii) 60 - 80% by weight particles made of at least one substance selected from the group consisting of tin and tin-copper alloys,
**characterised in that** the soldering paste comprises 3 - 30% by weight flux and **in that** the mean particle diameter of the copper particles and of the particles made of at least one substance selected from the group consisting of tin and tin-copper alloys is no more than 15 µm.

2. Soldering paste according to claim 1, **characterised in that** the soldering paste contains particles of a tin-copper alloy with a tin fraction in the range of 97 - 99.5% by weight and a copper fraction in the range of 0.5 - 3% by weight.

3. Method for connecting an electric component to a substrate in a material-bonded manner, comprising
a) providing an electronic component having a first surface to be connected and a substrate having a second surface to be connected;
b) applying to at least one of the surfaces to be connected a soldering paste according to claim 1 or 2 at an application thickness of at least 20 µm, which corresponds to the distance of the surfaces to be connected right before the soldering process;
c) arranging the electronic component and the substrate appropriately such that the first surface of the electronic component to be connected and the second surface of the substrate to be connected contact each other by means of the soldering paste; and
d) soldering the arrangement from c), which comprises the electronic component, the substrate, and the soldering paste situated between the first surface of the electronic component to be connected and the second surface of the substrate to be connected, in order to generate a material-bonded connection between the electronic component and the substrate.

4. Method according to claim 3, **characterised in that** the arrangement from d) is tempered in an additional step e) at a temperature of at least 40 - 217°C for a period of time in the range of 1 minute to 24 hours.

5. Method according to claim 3 or 4, **characterised in that** the substrate is selected from the group consisting of a printed circuit board, a lead frame, and a direct-bonded-copper substrate.

6. Arrangement produced according to a method according to any one of the claims 3 to 5, comprising an electronic component, a substrate, and, situated in between them, a contact layer that connects the electronic component and the substrate in material-bonded manner, **characterised in that** the contact layer comprises a fraction of eutectic phase and a fraction of inter-metallic phase, whereby the fraction of eutectic phase is in the range of 5-50% by weight, relative to the total weight of eutectic phase and intermetallic phase.

## Revendications

1. Pâte à braser contenant
(i) 10 - 30 % en poids de particules de cuivre,
(ii) 60 - 80 % nen poids d'au moins une matière qui est sélectionnée dans le groupe comportat de l'étain et des alliages d'étain et de cuivre, **caractérisée en ce, que** la pâte à braser comporte 3 - 30 % en poids de fondant et que le diamètre moyen des particules de cuivre et des particules de la matière, qui est sélectionnée dans le groupe comportant de l'étain et des alliages d'étain et de cuivre, n'est pas supérieur à 15 µm.

2. Pâte à braser selon la revendication 1, **caractérisée en ce, que** la pâte à braser comporte des particules d'un alliage étain-cuivre avec une part d'étain de 97 - 99,5 % en poids et une part de cuivre de 0,5 - 3 % en poids.

3. Procédé permettant d'assembler par liaison de matière un composant électronique à un substrat, selon lequel
a) on prépare un composant électronique avec une première surface à assembler et un substrat avec une deuxième surface à assembler,
b) on applique sur au moins une des surfaces à assembler une pâte à braser selon la revendication 1 ou 2 d'une épaisseur d'au moins 20 µm qui représente directement avant le brasage la distance entre les surfaces à assembler,
c) on dispose le composant électronique et le substrat de telle manière que la première surface à assembler du composant électronique soit en contact par l'intermédiaire de la pâte à braser avec la deuxième surface à assembler du substrat, et
d) on brase l'agencement décrit au point c) qui est constitué par le composant électronique, le substrat et la pâte à braser se trouvant entre la première surface à assembler du composant électronique et la deuxième surface à assembler du substrat, pour produire une liaison de matière entre le composant électronique et le substrat.

4. Procédé selon la revendication 3, **caractérisé en ce, que** dans une étape supplémentaire e), l'on soumette l'agencement de d) à une thermostatisation avec une température d'au moins 40 - 217 °C pendant une durée située dans une plage de 1 minute à 24 heures.

5. Procédé selon la revendication 3 ou 4, **caractérisé en ce, que** le substrat soit sélectionné dans un groupe composé d'un circuit imprimé, d'une grille de connexion (lead frame) et d'un substrat Direct bonded copper.

6. Agencement établi selon un procédé décrit selon les revendications 3 à 5, ledit agencement comportant un composant électronique, un substrat et - entre ces deux composants - une couche de contact qui assemble par liaison de matière le composant électronique et le substrat, **caractérisé en ce, que** la couche de contact présente une part de phase eutectique et une part de phase intermétallique, la part de phase eutectique rapportée au poids total de phase eutectique et de phase intermétallique étant située dans une plage de valeurs de 5 - 50 % en poids.
